Europäisches Patentamt

(19) European Patent Office

Office européen des brevets

(11) **EP 0 949 674 A2**

(12) **EUROPEAN PATENT APPLICATION**

(43) Date of publication:
13.10.1999 Bulletin 1999/41

(51) Int. Cl.$^6$: **H01L 21/8242**

(21) Application number: 99302567.5

(22) Date of filing: 31.03.1999

(84) Designated Contracting States:
AT BE CH CY DE DK ES FI FR GB GR IE IT LI LU MC NL PT SE
Designated Extension States:
AL LT LV MK RO SI

(30) Priority: 31.03.1998 US 52283

(71) Applicants:
• SIEMENS AKTIENGESELLSCHAFT
80333 München (DE)
• International Business Machines Corporation
Armonk, N.Y. 10504 (US)

(72) Inventors:
• Gruening, Ulrike
Wappering Falls, NY 12590 (US)

• Jaiprakash, Venkatachalam C.
Beacon, NY 12508 (US)
• Bronner, Gary
Stormville, NY 12582 (US)
• Radens, Carl
Poughkeepsie, NY 12603 (US)
• Beintner, Jochen
Wappingers Falls, NY 12590 (US)

(74) Representative:
Litchfield, Laura Marie et al
Haseltine Lake & Co.
Imperial House
15-19 Kingsway
London WC2B 6UD (GB)

(54) **Method of forming buried strap for trench capacitor**

(57)      The invention relates to reducing variations in thickness and height of the buried strap of a trench capacitor. Reduced variations in thickness and height is achieved by defining the top of the buried strap by recessing the poly in the trench to the top of the buried strap. The collar is then recessed to below the top surface to define the bottom of the buried strap. A poly layer is deposited to line the sidewalls of the trench top surface of the poly trench fill, and recessed region above the collar. A etch is then used to remove the excess poly layer from the sidewalls and top surface of the poly trench fill, leaving the recessed region above the collar filled to form the buried strap. The etch removes the poly in the vertical and horizontal direction at about the same rate.

FIG. 8

FIG. 9

FIG. 7

FIG. 10

FIG. 11

**Description**

This invention relates to a method of semiconductor device fabrication and more particularly, to a method providing improved control of a buried strap height for example for trench capacitors.

Fabrication of semiconductor devices with trench capacitors typically include a node isolated by a collar and a shallow trench isolation (STI). A buried strap is placed into the trench and doped to provide an electrical connection to the node of the trench capacitor.

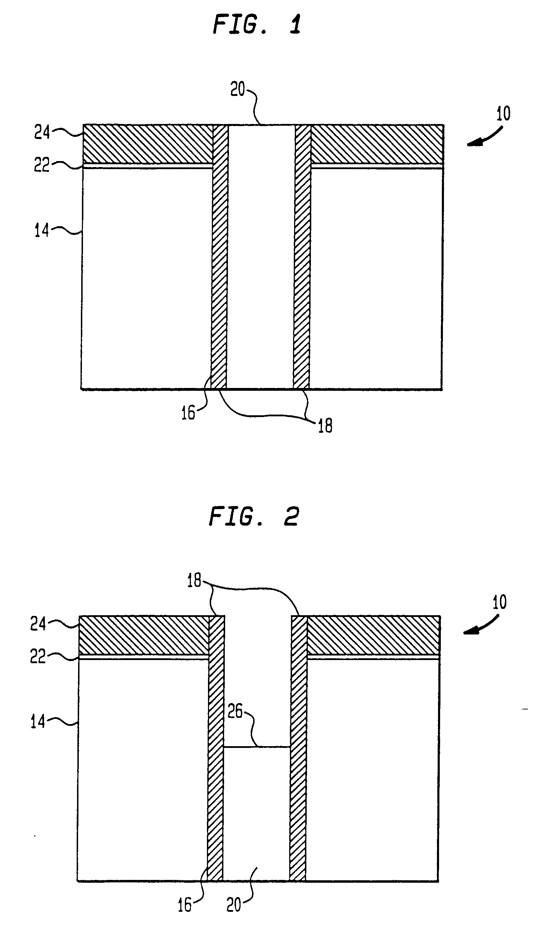

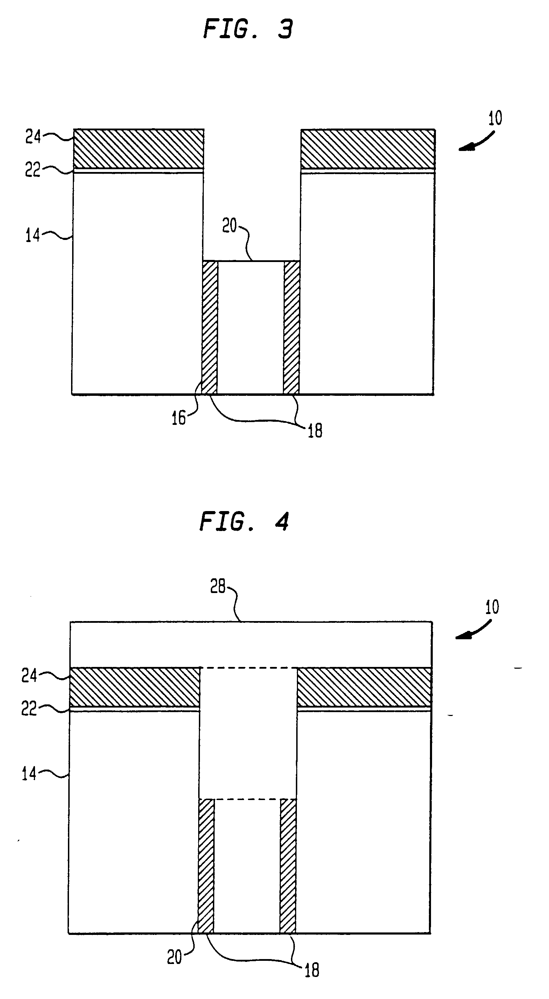

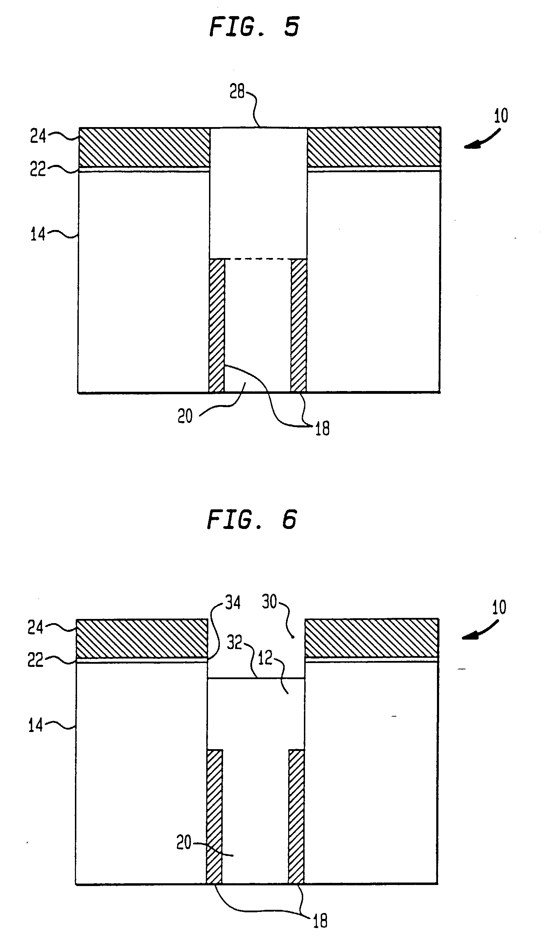

The buried strap must be formed within a predetermined height range in order to perform properly during operation of the semiconductor device. Referring to FIGS. 1-6, a known process of forming a buried strap 12 (FIG. 6) on a semiconductor device 10 is illustrated. Referring specifically to FIG. 1, a substrate 14 has trenches 16 formed therein. Trench 16 is lined with a collar 18 in its upper portion. Typically, the collar is formed from an oxide such as silicon dioxide, and filled with polycrystalline silicon 20 (polysilicon or poly). Prior to the formation of trench 16, a pad stack is formed on the surface of substrate 14. Typically, the pad stack comprises various device layers such as, for example, a pad oxide 22 and a pad nitride layer 24 that serves as a polish stop. Additionally, a hard mask layer (not shown) comprising TEOS or other appropriate material is formed over the pad stack. Illustratively, the hard mask layer is removed after the formation of the trenches. In some application, the hard mask layer is removed later on in the process. The structure in FIG. 1 has been polished to planarize the top surface.

Referring to FIG. 2, polysilicon 20 is etched to a predetermined depth to form a recess 26. This recess is often referred to in the art as "recess 2". FIG. 3 illustrates a wet etch of collar 18 to remove collar 18 from sidewalls of trench 16. Referring to FIG. 4, trench 16 is filled with additional polysilicon 28 which is deposited over the surface of the semiconductor device 10 as well, i.e. on nitride layer 24. To remove polysilicon 28 deposited on top of nitride layer 24 a chemical-mechanical polish (CMP) process is performed resulting in the structure shown in FIG. 5. Referring to FIG. 6 an additional etching step is performed to remove another portion of polysilicon 28 and form a recess 30. Recess 30 is referred to in the art as "recess 3". The remaining portion of polysilicon 28 becomes buried strap 12.

Buried strap 12 has height defined as the difference in distance between a top surface 32 of buried strap 12 and a top surface 34 of collar 18. The process described above includes many steps. In particular, a recess 2 formation, a wet collar etch and a recess 3 formation. Each step provides a desired depth of the feature formed within that step and a desired variation range. To illustrate this, an example is presented below which calculates the desired depth of a buried strap and the range of variation based on the data in Table 1.

Table 1

| Step | Nominal Desired Depth below Substrate (Å) | Variation of Depth (Å) | Basis for Estimate of Variation (Å) |
|---|---|---|---|
| Recess 2 | 1000 | 500 | 20% of: recess 2 depth (1000) + pad nitride thickness (1500) |
| Collar Wet Etch | 500 | 50 | 10% of depth |
| Recess 3 | 500 | 400 | 20% of: recess 3 depth (500) + pad nitride thickness (1500) |

Based on the above data the nominal buried strap height can be estimated as follows:

$$BS = 1000 + 500 - 500 = 1000 \text{ Å}$$

The variation can be estimated by the following calculation:

$$V = \ddot{O}\_(500^2 + 50^2 + 400^2) = 640 \text{ Å}$$

Therefore, the BS height can be expressed in this example as 1000 ±640 Å.

The method of the invention seeks to reduce the variation of a buried layer height during fabrication of the buried strap.

According to the present invention, there is provided a method of fabricating a buried strap as claimed in claim 1.

In accordance with the invention, buried straps having reduced variations in height and thickness are produced.

For a better understanding of the present invention, and to show how it may be brought into effect, reference will now be made, by way of example, to the accompanying drawings, in which:

Figures 1-6 show a known process for forming the buried strap; and

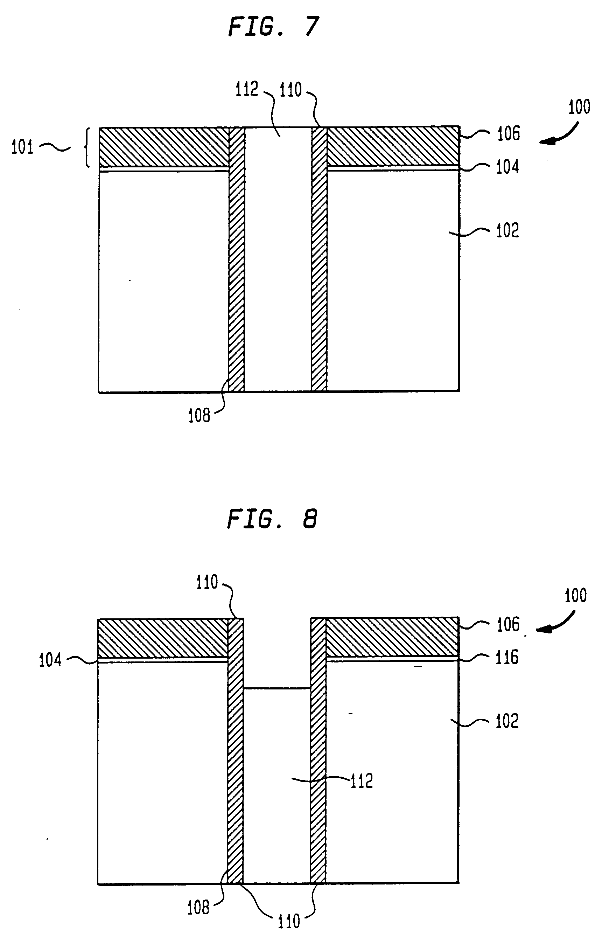

Figures 7-20 show illustrative embodiments of the invention for forming a buried strap and an isolation region.

The present disclosure relates to a method for more accurately controlling the height of a buried strap, such as those employed in trench capacitors. Known processes for forming buried straps produce large variations in buried strap height across the device. Large variations in buried strap height reduces the ability to control strap outdiffusion resulting in larger outdiffusion as well as variations in outdiffusion which reduces transistor performance. By controlling buried strap height, better control of strap height and better performance is achieved. For example, if large variations in buried strap height are possible then thicker buried straps are required to ensure that the minimum design requirements are always met, but by being more able to accurately control buried strap height the invention enables better control of outdiffusion, leading to better component performance.

To facilitate discussion, the invention is described in the context of a trench capacitor. However, the invention is broader and is applicable to buried layers in semiconductor devices. The devices, for example, include memory integrated circuits (ICs) such as random access memories (RAMs), dynamic random access memories (DRAM), synchronous DRAMs (SDRAMs), or high speed type DRAMs. Devices such as application specific ICs (ASICs), merged DRAM-logic circuits (embedded DRAMs), or any other logic circuits are also applicable. Typically, the devices are used in, for example, consumer products such as computer systems, cellular phones, personal digital assistants (PDAs), and other electronic products.

Referring now in specific detail to the drawings in which like reference numerals identify similar or identical elements throughout FIG. 1 illustrates the prior art structure of a filled trench which has been polished to planarize the top surface. The structure, as show in FIG. 1, is then processed in accordance with the present invention as described below.

Referring to FIG. 7, semiconductor chip 100 is shown having a substrate 102 which is formed from silicon. Other types of semiconductor substrates are also useful. Substrate 102 has a pad stack 101 is formed thereon. The pad stack comprises various layers that serve to facilitate processing of the semiconductor chip. Typically, the pad stack comprises a pad oxide layer 104 formed by, for example, exposing substrate 102 to oxygen under elevated temperature conditions. A pad etch stop layer 106 is formed over the pad oxide layer. In one embodiment, the pad etch stop layer comprises silicon nitride formed by using a chemical vapor deposition (CVD) process, for example low pressure chemical vapor deposition (LPCVD) or plasma enhanced chemical vapor deposition (PECVD). Other types of etch stop layers are also useful. The pad stack may include an additional layer or layers, such as a hard mask layer (not shown). Typically, the hard mask layer is removed after the formation of the trench.

The substrate includes a partially completed trench capacitor. A collar 110 is provided in the upper portion of the trench capacitor. The collar comprises, for example, dielectric material such as oxide formed from tetraethyloxosilane (TEOS). A nitride layer may be provided over the oxide collar to improve collar isolation characteristics. A filler material 112 fills the trench 108, lining the inner sidewalls of the collar. The filler material comprises, for example, polysilicon. The use of amorphous silicon is also useful. In one embodiment, the filler material is doped with, for example, n-type dopants such as arsenic or phosphorus. The formation of the trench capacitor up to this point is achieved using conventional techniques. Such techniques are described in, for example, Nesbit et al., "A 0.6 um$^2$ 256 Mb Trench DRAM Cell with Self-Aligned BuriEd STrap (BEST)," IEDM Technical Digest (1993).

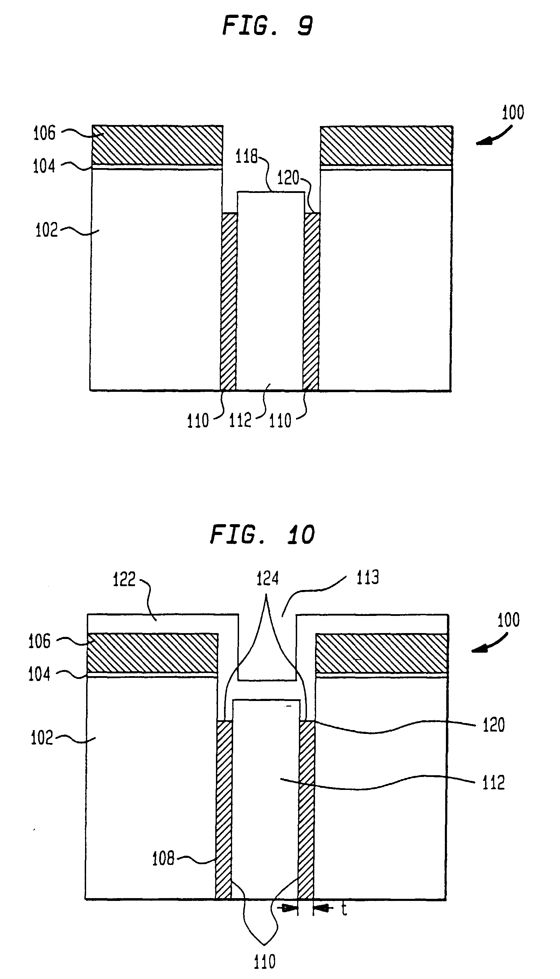

Referring to FIG. 8, filler 112 is recessed to a predetermined depth. In accordance with the invention, the depth of the recess effectively defines the top of a buried strap. Subsequent processes may result further recessing of the filler material. However the additional recess by subsequent processes is rather insignificant. Typically, the depth of the recess is about 50 nm. Of course, the actual depth depends on design parameters and may vary accordingly. The recess is achieved by for example, a dry etch or other etch processes.

Referring to FIG. 9, the exposed portion of the collar 110 is removed by a wet etch process using, for example, HF chemistry. The collar is recessed below a top surface 118 of the filler material 112 to a depth 120. Depth 120 defines the bottom of the buried strap. As such, the distance between 120 and 118 determines the thickness of the buried strap. In accordance with one embodiment of the invention, depth 120 is about 50-60 nm. This creates a buried strap depth of about 50-60 nm.

Referring to FIG. 10, a layer 122 is deposited on semiconductor device 100. Layer 122, for example, comprises silicon. The silicon layer, for example, is deposited by conventional techniques such as, for example, a chemical vapor deposition (CVD) process. The deposited silicon layer, in one embodiment, is polysilicon. Also, depositing silicon amorphously is also useful. In some applications, layer 122 may be doped with dopants of the same type as the filler material. In one embodiment, the dopants are n-type such as arsenic or phosphorus.

The silicon layer 122 fills the recessed portion 124 of the collar. The thickness of the layer is at least half the thickness of the collar to ensure that the silicon layer sufficiently fills the recessed portion of the collar. Preferably, the thickness of the collar fills the recessed portion without filling the recessed portion 113 of the trench. In one embodiment, the thickness of the silicon layer is greater than half the thickness of the collar but less than half the width or diameter of the trench, preferably greater than half the thickness of the collar but less than or equal to a forth of the width of the trench. Typically, the trench shape is circular. However, other trench shapes are also useful. For trench shapes other than circular, the width or diameter is taken to be the narrowest portion of the trench or smallest diameter possible. This ensures that the trench is not completely filled. For typical applications having a collar thickness of about 150 - 350 Å, the thickness of the silicon layer is from about 75 to 300 Å, preferably about 200 to 275 Å, and more preferably about 225 - 250 Å.

Furthermore, it is desirable to have the silicon layer just thick enough to fill the recessed portion as this would reduce the etch time required to remove the excess silicon layer from the surface of the substrate, sidewalls of the collar, and over the surface 126 of filler material 112. Additionally, the thinner the silicon layer enables oxidation of the portions of the layer lining the trench sidewalls and top surface of the filler material. Therefore, it is preferable that the layer thickness is greater than half the collar thickness and sufficiently thin to enable oxidation of the layer. In one embodiment, the thickness of the silicon layer is about half the thickness of the collar + 20% to ensure the filling of the depression region. Preferably, the thickness of the silicon layer is half the thickness of the collar + 10%.

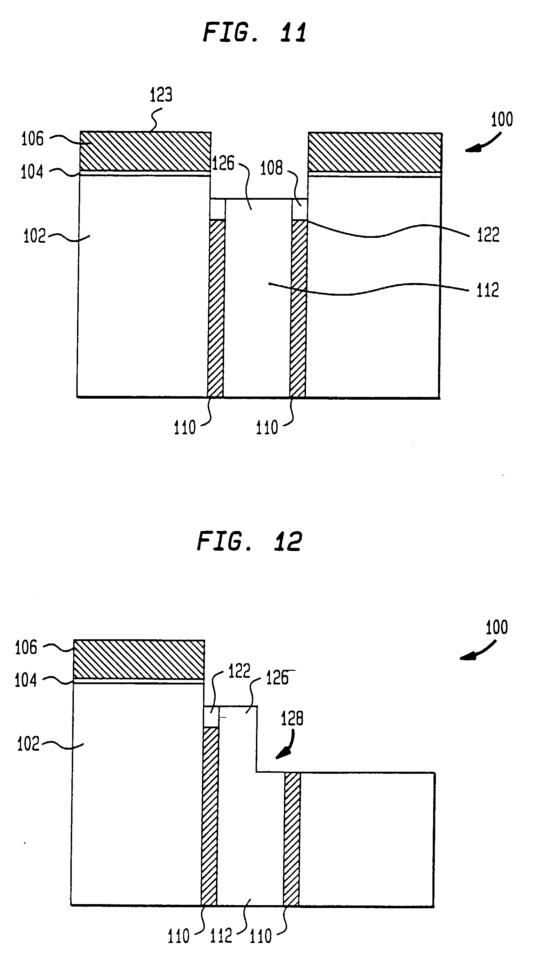

Referring to FIG. 11, layer 122 is removed from lateral sides of trench 108 and from a top surface 123 of semiconductor device 100, leaving the recessed region 124 filled with material of layer 122. Layer 122 is removed by a etching process which removes portions of layer 122 at comparable rates in both vertical and horizontal directions. The etch process includes a chemical dry etch (CDE) using, for example, $CF_4$ chemistry. Typical reactants and process conditions for the $CF_4$ CDE include, for example, introducing into the reaction chamber about 100 to about 120 sccm of $O_2$ and about 50 to 60 sccm of $CF_4$ at a pressure of about 35 mTorr to 45 mTorr for about 25 seconds to 35 seconds. Other CDE chemistries are also useful. The etch process may also include introducing compounds such as $N_2$ or inert compounds such as He or Ar. The radio frequency (RF) power used in the etch process is preferably between about 450 and 550 Watts. Those skilled in the art may alter the power conditions to increase or decrease the etch rate. It may be advantageous to slow the etch rate so as to ensure proper removal of layer 122. This includes removing layer 122 from the surface of the pad stack, sidewalls of the collar, and surface of filler 112, leaving the recessed region 124 filled with portions of layer 122. A buried strap 126 is created after the etch process. Buried strap 126 includes a portion of layer 122 and a portion of filler 112. The buried strap is formed from conductive material or made conductive by further processing.

The invention as described thus far results in the formation of buried straps reduced variations in height or depth across the wafer. Improved control in depth enables the formation of the capacitors with a thinner and shallower buried straps. A shallower and thinner strap results in a smaller junction, advantageously reducing leakage current and increasing retention time.

The present invention has been able to improve variations in height of the buried layer to about 40 - 50 Å. This is almost an order of magnitude better than conventional processes have variations in height of about 600 Å. Thus, the invention enables the use of a thinner buried strap. For example, buried straps of about 400 -500 Å thick are used while conventional processes require the buried strap thickness to be about 1000 Å. As described, the present invention is able to achieve a reduced buried strap thickness of about 50% of conventional processes. Of course actual buried strap thickness depends on design parameters such as resistance.

Referring to FIG. 12, the structure of FIG. 11 is further processed. Such processing includes, for example, defining the active area (AA) of the semiconductor device. Defining the AA is achieved using conventional lithographic techniques. Such techniques include depositing a resist layer over the wafer. The resist, which serves as etch mask, is patterned by selectively exposing it with an exposure source and mask to define the AA region. Depending on whether a positive or negative resist is used, either the exposed or unexposed portions of the resist layer are removed during development. The removed portions of the resist layer expose the non-active region and the remaining resist portions protect the AA.

An anti-reflective coating (ARC) layer may be deposited on the substrate surface prior to the deposition of the resist layer. The ARC layer is used to improve the lithographic resolution. The ARC layer, for example, is deposited by spin-on techniques, filling the trench and providing a planar surface.

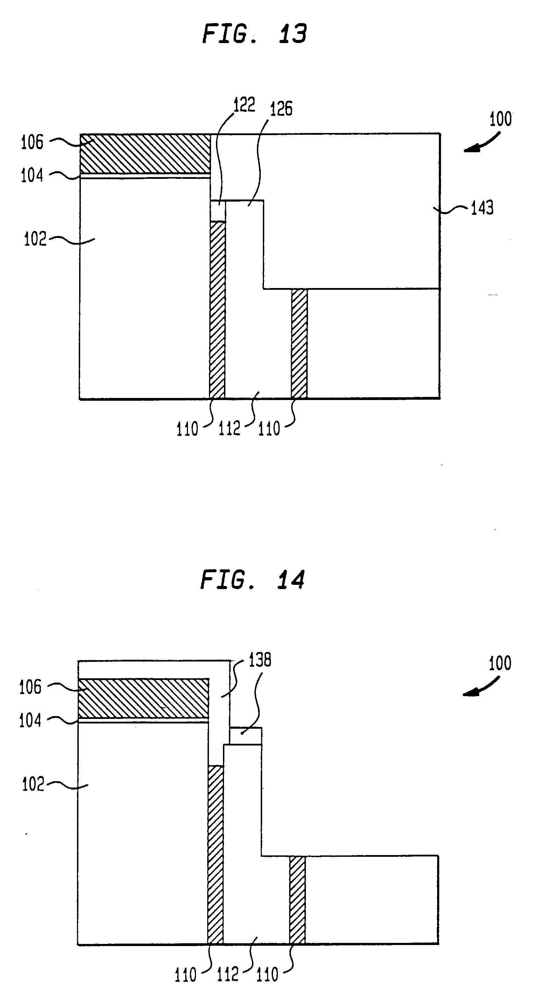

The non-active region is anisotropically etched by, for example, RIE to form a shallow trench 128. Referring to FIG. 13, a dielectric material 143 such as TEOS is deposited, filling the shallow trench. The excess TEOS material is planarized to result in a shallow trench isolation (STI). As shown, the STI overlaps a portion of the trench. The bottom of the STI is below the top of the oxide collar. The bottom is sufficient deep to isolate the buried strap from adjacent capacitors or circuit elements. Typically, the STI is about 2500 Å.

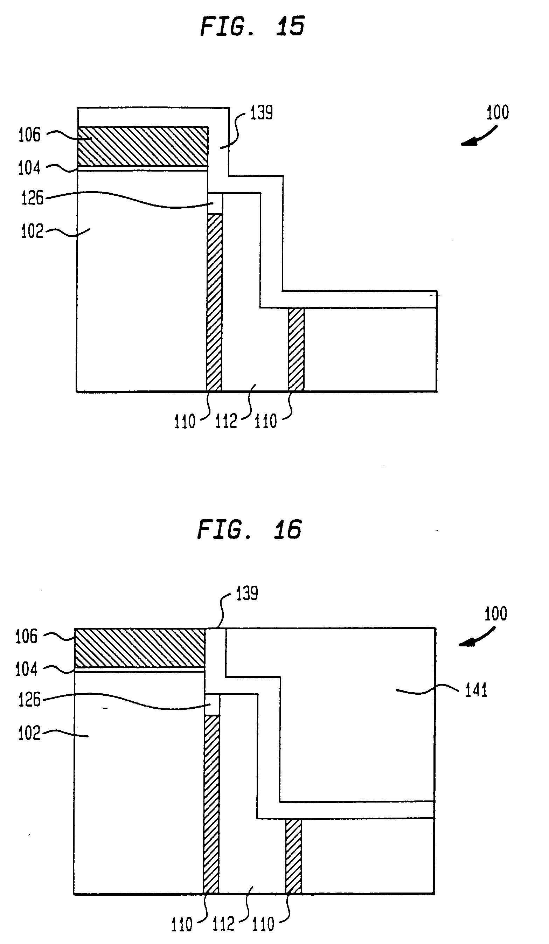

Referring to FIGS. 14 and 15, an alternate method of forming an STI is provided. This method advantageously does not require etching layer 122 prior to active area masking and etching. Beginning with the structure shown is FIG. 10, a portion of buried strap 126, collar 110 and dielectric layer 106 is masked, and a portion remaining exposed is removed by an etching process, for example, reactive ion etching (RIE), resulting in the structure of FIG. 14. Exposed polysilicon 138 is oxidized to form a dielectric 139 on exposed surfaces, as shown in FIG. 15. A dielectric material 143, for example, an oxide, is used to form STI as shown in FIG. 16.

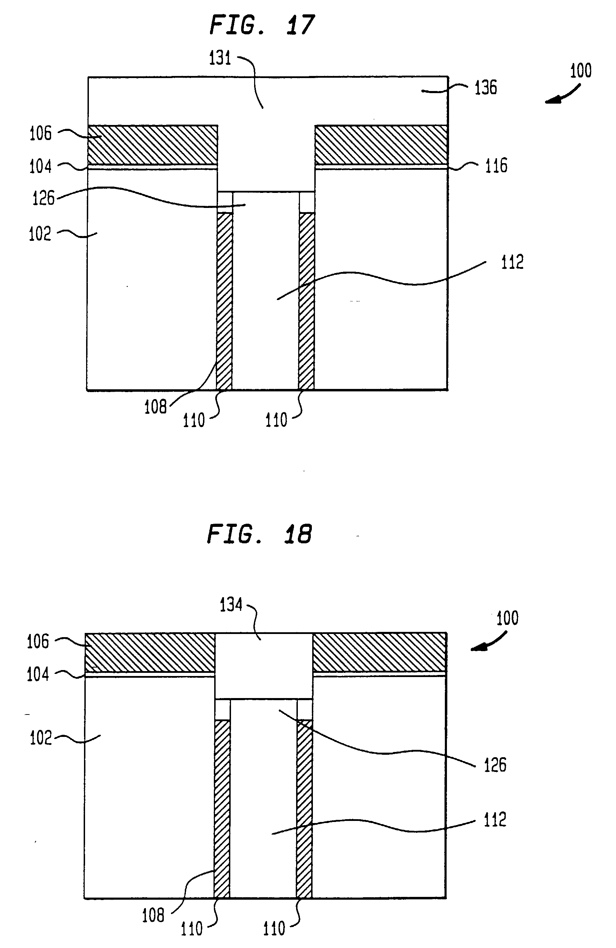

In an alternative embodiment, a raised shallow trench isolation (RSTI) as known to those skilled in the art is employed. Referring to FIGS. 17 and 18, a trench top isolation 134 is formed within the trench 108 by filling the structure shown in FIG. 11 with a material 131, preferably oxide. Material 131 contacts layer 122 in trench 108 and on the surface of semiconductor device 100. Excess material 136 is removed from the surface of semiconductor device 100 by etching or CMP. The process for forming the RSTI continues, as described in Alsmeier et al., "A Novel 16b Trench DRAM Cell with Raised Shallow Trench Isolation (RSTI)," Symposium VLSI Technical Digest (1977), for example, which is herein incorporated by reference for all purposes. Dielectric layer 106 and pad layer 104 may be removed and gate formation for transistors may begin as is known in the art.

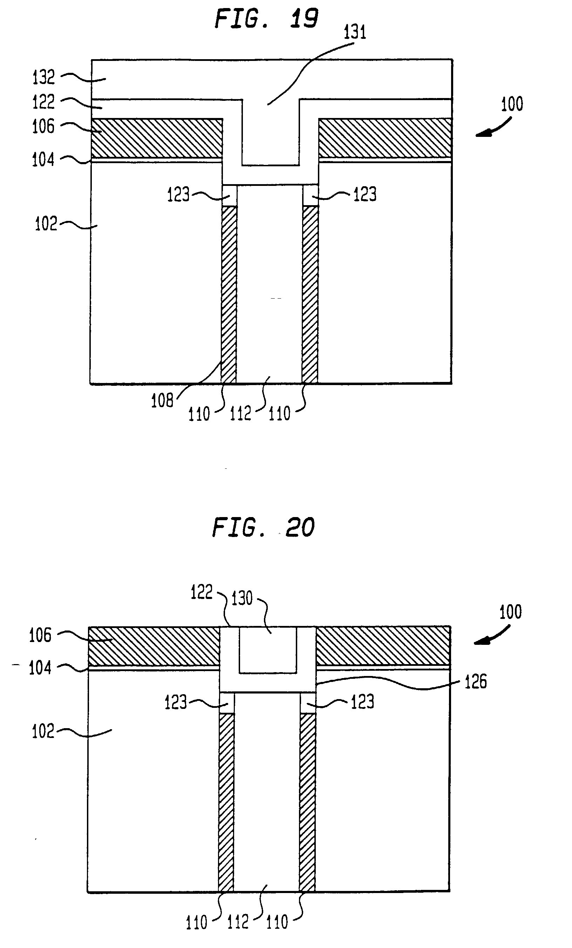

Referring to FIGS. 19 and 20, an alternate method of forming a trench top isolator 130 for a raised shallow trench isolation (RSTI) does not require etching layer 122 prior to depositing material 131. Beginning with the structure of FIG. 10, trench top isolator is formed by depositing material 131, preferably oxide, into trench 108. Material 131 contacts layer 122 in trench 108 and on the surface of the semiconductor chip 100. Excess material 132 is removed from the surface of semiconductor device 100 by etching or CMP. Part of layer 122 which is above the top surface of filler 112 is oxidized to create a dielectric material similar to layer 139 in FIG. 15. An unoxidized portion 123 remains as part of buried strap 126. This method eliminates the need for etching layer 122 by an etch process thereby further reducing process time. The process for forming the RSTI continues, as described in Alsmeier et al., "A Novel 16b Trench DRAM Cell with Raised Shallow Trench Isolation (RSTI)," Symposium VLSI Technical Digest (1977), for example, which is herein incorporated by reference for all purposes. Dielectric layer 106 and pad layer 104 may be removed and gate formation for transistors may begin as is known in the art.

Having described illustrative methods of controlling a buried strap height (which are intended to be illustrative and not limiting), it is noted that modifications and variations can be made by persons skilled in the art in light of the above teachings. It is therefore to be understood that changes may be made in the particular embodiments of the invention disclosed which are within the scope and spirit of the invention as outlined by the appended claims. Having thus described the invention with the details and particularity required by the patent laws, what is claimed and desired protected by Letters Patent is set forth in the appended claims.

## Claims

1. A method of fabricating a semiconductor device having a buried layer comprising:

   providing a substrate having a trench formed therein, wherein the trench is filled with a filler material and includes a collar surrounding at least an upper portion of the trench sidewalls;

   recessing the filler material to below the surface of the substrate, the recess effectively defining a top surface of the buried layer;

   recessing the collar below the top surface of the filler material to form a depression region surrounding the filler material;

   depositing a layer over the substrate, the layer lining sidewalls of the trench, top surface of the filler material, and filling the depression region;

   removing the layer from the sidewalls of the trench and top surface of the filler material, leaving materials from the layer filling the depression region, wherein the layer is removed by means of an etch which etches in a vertical and horizontal direction at comparable rates.

2. A method of fabricating a semiconductor device as claimed in claim 1, wherein the trench forms part of a trench capacitor.

3. An integrated circuit fabricated using the method of claim 1 and 2.

EP 0 949 674 A2

# FIG. 1

# FIG. 2

7

## FIG. 3

## FIG. 4

# FIG. 5

# FIG. 6

## FIG. 7

## FIG. 8

# FIG. 9

# FIG. 10

## FIG. 11

## FIG. 12

## FIG. 13

## FIG. 14

## FIG. 15

106
104
126
102
139
100

110  112  110

## FIG. 16

106
104
126
102
139
100
141

110  112  110

EP 0 949 674 A2

## FIG. 17

131

136

100

106

104

116

126

102

112

108

110    110

## FIG. 18

134

100

106

104

102

126

112

108

110    110

## FIG. 19

## FIG. 20